# EUROPEAN PATENT APPLICATION

(11) **EP 2 384 092 A1**
(43) Date of publication of application: **02.11.2011**
(21) Application number: 10735717.0
(22) Date of filing: 19.01.2010
(51) Int. Cl.: H05B 33/10, G09F 9/30, H01L 27/32, H01L 51/50, H05B 33/02, H05B 33/04, H05B 33/06, H05B 33/12

(54) **DISPLAY PANEL PRODUCING METHOD AND SUBSTRATE FOR DISPLAY DEVICE**

(30) Priority: 27.01.2009 JP 2009014916
(71) Applicant: Sumitomo Chemical Company, Limited, Tokyo 104-8260 (JP)
(72) Inventor: NISHIOKA, Yukiya, Nara-shi Nara 631-0034 (JP); KURIHARA, Takashi, Tsukuba-shi Ibaraki 305-0045 (JP); KAJITANI, Masaru, Niihama-shi Ehime 792-0025 (JP)
(74) Representative: Jackson, Martin Peter
(86) International application number: PCT/JP2010/050549
(87) International publication number: WO 2010/087248

(57) **Abstract**

A method for manufacturing a display panel comprises the steps of: forming a display device substrate 60 by providing on a first substrate 20, which is equipped with a color filter 30 on which a plurality of filter elements are arranged, a plurality of organic electroluminescent elements 40, which have the same structure as each other and which is individually equipped with a connection electrode formed with a connection terminal 46a, so that each of organic electroluminescent elements is overlapped with each of the filter elements; preparing a driving substrate 50, which comprises a driving circuit for driving the plurality of and a connection portion 52a that establishes electrical connection to the driving circuit; arranging a laminating material 74X on a surface of the display device substrate or the driving substrate so as to enclose the plurality of organic electroluminescent elements when the display device substrate and the driving substrate are laminated; and laminating the display device substrate and the driving substrate so that the connection terminal and the connection portion come into contact each other.

## Description

### TECHNICAL FIELD

The present invention relates to a method for manufacturing a display panel comprising a plurality of organic electroluminescent elements (hereinafter, referred to as "organic EL element"), a display device substrate used in this manufacturing method, a display panel comprising this display device substrate, and a display device comprising this display panel.

### BACKGROUND ART

The development of flat panel displays (hereinafter, referred to as "organic EL display device" or simply "display device") that use self-emitting type organic EL elements as a pixel light source is progressing. In organic EL display devices mounted is a display panel that outputs three kinds of light, red, green, and blue, enabling a color display to be achieved by superimposing the three kinds of light at a predetermined light intensity ratio.

A display panel for color display can be realized by providing three kinds of organic EL element, which respectively emit red, green, and blue light on a drive substrate formed with a circuit for individually driving the organic EL elements. One proposal of such a display panel has a DOD structure (dual-plate OLED display structure), in which a display panel substrate having three kinds of organic EL element formed on a substrate and a drive substrate formed with a TFT (thin film transistor) are laminated facing each other (for example, refer to Non Patent Literature 1).

However, the more kinds of organic EL element that have to be formed, the greater the number of manufacturing steps, and the more difficult the manufacturing steps themselves become. As a result, there is the problem that display device throughput and yield deteriorate. For example, to form three kinds of organic EL element, it is necessary to selectively form three kinds of light-emitting layer at respective predetermined positions. Consequently, when forming the light-emitting layer by a vapor deposition method, the vapor deposition step needs to be carried out three times. Further, to avoid the problem of color mixing, the requirements for positional accuracy when forming the light-emitting layer increase. When forming the light-emitting layer by a coating method, since the coating solutions need to be separately coated on respective predetermined regions, the same problems as for vapor deposition occur.

One solution to the above-described problems would be a display panel having a structure that comprises only one kind of organic EL element. For example, a display panel has been proposed that has a configuration which outputs three kinds of light using one kind of organic EL element that emits white light by combining this organic EL element with a color filter that selectively transmits light in predetermined wavelengths (for example, refer to Patent Literature 1).

### Patent Document

Patent Document 1 : JP 2000-111721 A

### Non Patent Document

Non Patent Document 1: 2008 SID (Society for Information Display) International Symposium, Seminar, Exhibition Proceedings, May 18 2008, 3.2, p. 5 to p. 8, Chang-Wook Han, 15-in XGA Dual-Plate OLED Display (DOD) Based on Amorphous Silicon (a-Si) TFT Backplane

### DISCLOSURE OF INVENTION

### PROBLEM TO BE SOLVED BY THE INVENTION

However, the display panel disclosed in Patent Literature 1 simply has the organic EL elements formed on a color filter. Since the display panel does not have a circuit for individually driving the organic EL elements, to employ this display panel as an active matrix type display panel, it is necessary to additionally form a driving circuit on the organic EL elements formed on the color filter. To form the driving circuit, a high-temperature treatment is required, which means that during this process the organic EL elements are exposed to a high temperature. However, organic EL elements are degraded by exposure to high temperatures. Therefore, it is not practical to manufacture a high-reliability active matrix type display panel using the conventional display panel discussed in Patent Literature 1.

Accordingly, it is an object of the present invention to provide a method for manufacturing that enables a display panel having a driving circuit for individually driving a plurality of organic electroluminescent elements to be manufactured by simple steps at a good yield. Further, it is also an object of the present invention to provide a display device substrate having a structure that is suited to the method for manufacturing.

### MEANS FOR SOLVING PROBLEM

To solve the aforementioned problem, the present invention adopt the following configurations:
[1] A method for manufacturing a display panel, comprising the steps of:
   forming a display device substrate by providing on a first substrate which is equipped with a color filter on which a plurality of filter elements that selectively output light in a specific wavelength are arranged, a plurality of organic electroluminescent elements which have the same structure as each other and which is individually equipped with a connection electrode formed with a connection terminal, so that each of organic electroluminescent elements is overlapped with each of the filter elements when viewing in a thickness direction of the first substrate;
   preparing a driving substrate which comprises a driving circuit for individually driving the plurality of organic electroluminescent elements and a connection portion that establishes electrical connection to the driving circuit;
   arranging a laminating material on a surface of the display device substrate or the driving substrate so as to enclose the plurality of organic electroluminescent elements when the display device substrate and the driving substrate are laminated so that the connection terminal and the connection portion come into contact each other; and
   a laminating step of laminating the display device substrate and the driving substrate so that the connection terminal and the connection portion come into contact each other.
[2] The method for manufacturing a display panel according to above [1], wherein the step of forming a display device substrate comprises forming the connection terminal in a protruding manner by forming a protruding portion that protrudes from the color filter and providing the connection terminal on the protruding portion.
[3] The method for manufacturing a display panel according to above [1] or [2], wherein the laminating step is carried out under a condition in which a gap defined between the display device substrate and the driving substrate is vacuumized.
[4] The method for manufacturing a display panel according to any one of [1] to [3], wherein the laminating step is carried out under a condition in which a gap defined between the display device substrate and the driving substrate is under nitrogen atmosphere, and
   the method further comprises, after the laminating step, pressure-welding the connection terminal and the connection portion; and curing the laminating material.
[5] The method for manufacturing a display panel according to any one of [1] to [4], wherein in the step of arranging a laminating material, a frit sealing material that contains a low melting point glass powder is used as the laminating material, and
   the method further comprises, after the laminating step, curing the laminating material by irradiating laser light on the frit sealing material.
[6] The method for manufacturing a display panel according to any one of [1] to [5], wherein in the step of forming a display device substrate, the plurality of organic electroluminescent elements are formed by forming a light-emitting layer using a coating method.
[7] The method for manufacturing a display panel according to any one of [1] to [6], wherein in the step of forming a display device substrate, the first substrate which is equipped with the color filter consisting of a colored layer is prepared, and the plurality of organic electroluminescent elements are formed in contact with the colored layer.
[8] A display device substrate to be laminated facing a driving substrate that comprises a driving circuit for individually driving a plurality of organic electroluminescent elements and a connection portion which is provided corresponding to each organic electroluminescent element and establishes electrical connection to the driving circuit, the display device substrate comprising:
   a first substrate equipped with a color filter on which a plurality of filter elements that selectively output light in a specific wavelength are arranged; and
   the plurality of organic electroluminescent elements having the same structure as each other, each arranged on the first substrate so as to overlap each of filter elements when viewing in a thickness direction of the first substrate, wherein
   each of the plurality of organic electroluminescent elements is equipped with a connection electrode on which a connection terminal for connecting to the connection portion is formed.
[9] The display device substrate according to above [8], wherein the plurality of organic electroluminescent elements comprises a light-emitting layer that emits white light.
[10] A display panel comprising:
   a driving substrate comprising a driving circuit for individually driving a plurality of organic electroluminescent elements, and a connection portion which is provided corresponding to each organic electroluminescent element and establishes electrical connection to the driving circuit; and
   the display device substrate according to above [8] or [9], wherein
      the display panel is formed by laminating the driving substrate and the display device substrate so that the connection terminal and the connection portion are in a contacting state.
[11] A display device comprising the display panel according to above [10].

### EFFECT OF THE INVENTION

In the method for manufacturing a display device substrate according to the present invention, a display device substrate formed by providing on a first substrate, which is equipped with a plurality of filter elements, a plurality of organic EL elements having the same structure as each other, and a driving substrate formed with a driving circuit are separately prepared. Then, the display device substrate and the driving substrate are laminated. Consequently, deterioration of the organic EL elements during formation of the driving circuit can be prevented, and deterioration of the driving circuit during formation of the organic EL elements can be prevented. As a result, a display panel having a driving circuit for individually driving a plurality of organic electroluminescent elements can be manufactured by simple steps at a good yield.

Further, since a plurality of organic EL elements having the same structure as each other are formed on a color filter, when forming the light-emitting layer of the organic EL elements, it is not necessary to manufacture a plurality of kinds (for example, three kinds) of light-emitting layer. Therefore, when forming the light-emitting layer by vapor deposition, the light-emitting layer for all of the organic EL elements can be formed in one vapor deposition step. Further, when forming the light-emitting layer by a coating method, there is no need for a high-precision technique for separately coating the light-emitting materials, so that the light-emitting layer can be formed in one coating step by a simple method such as a spin coating method or a capillary coating method.
Thus, because the manufacturing steps can be simplified, an increase in the number of steps can be suppressed, and stable manufacturing can be achieved, throughput and yield can be improved. Consequently, the failure rate of the manufactured display device substrates and of a display device substrate embedded in display panels can be reduced.

In the method for manufacturing a display panel according to the present invention, even if a failure in the display device substrate is discovered after the driving substrate and the display device substrate have been laminated, since the organic EL elements are not formed on the driving substrate, the expensive driving substrate can be easily removed and reused (reworked). Accordingly, additional cost reductions can be achieved.

In addition, in the method for manufacturing a display panel according to the present invention, since the organic EL elements are provided without providing a space between the organic EL elements and the color filter, water vapor, oxygen and the like can be prevented from coming into contact with the organic EL elements. Consequently, an extension of life time for the organic EL elements can be achieved.

In the display panel according to the present invention, the organic EL elements are provided on a color filter. Even if there was a predetermined gap defined between the organic EL elements and the color filter, when the display screen is viewed from a direction perpendicular to the screen (hereinafter, "screen perpendicular direction"), since each of the organic EL elements is overlapped with each of the filter elements when viewing in the screen perpendicular direction, the light emitted from each organic EL element is perceived as passing through the filter element arranged at an overlapping position as viewed from the screen perpendicular direction. For that reason, the problem of color mixing does not occur. However, when the display screen is viewed from an oblique direction to the screen, the light emitted from each organic EL element may be perceived as passing through the filter element arranged adjacent to the filter element arranged at the overlapping position as viewed from the screen perpendicular direction. Consequently, although the problem of color mixing arises depending on the angle that the display screen is viewed at, in the present invention, since the organic EL elements are provided on the color filter, the gap defined between the organic EL elements and the color filter can be narrowed. Further, since in some cases the organic EL elements can also be arranged in contact with the color filter, the perception that the light emitted from each organic EL element is passing through the filter element arranged adjacent to the filter element arranged at the overlapping position as viewed from the screen perpendicular direction can be prevented. Consequently, the problem of color mixing can be suppressed.

### BRIEF DESCRIPTION OF DRAWINGS

FIG. 1 is a plan view schematically illustrating the configuration of a display panel.
FIG. 2 is a cross sectional view schematically illustrating the configuration of a display panel as viewed along the cross sectional line II-II in FIG. 1.
FIG. 3 is a schematic cross sectional view illustrating the configuration of a color filter.
FIG. 4 is a diagram schematically illustrating a cross section when a display panel is laminated as viewed along the cross sectional line IV-IV in FIG. 1.

### BEST MODE(S) FOR CARRYING OUT THE INVENTION

Embodiments of the present invention will now be described with reference to the drawings. To allow the invention to be easily understood, the shape, size, and arrangement of the constituent elements are merely schematically illustrated. The present invention is not limited to the following description. Further, the respective constituent elements may be appropriately changed within the scope of the invention. In the figures used in the following description, constituent elements that are the same are denoted with the same reference numerals, and repetitive descriptions in separate embodiments may be omitted. In addition, although there are parts such as electrode leads in the device in which the organic EL elements are mounted, a description of such parts may be omitted since they have no direct bearing on the description of the present invention. The device according to the present invention in which organic EL elements are mounted is not necessarily manufactured or used with the exemplified arrangement. Further, in the following description, one of the directions in the thickness direction of the substrate may be referred to as "up" or "above", while the other direction in the thickness direction may be referred to as "down" or "below".

### <Example of Display Panel Configuration>

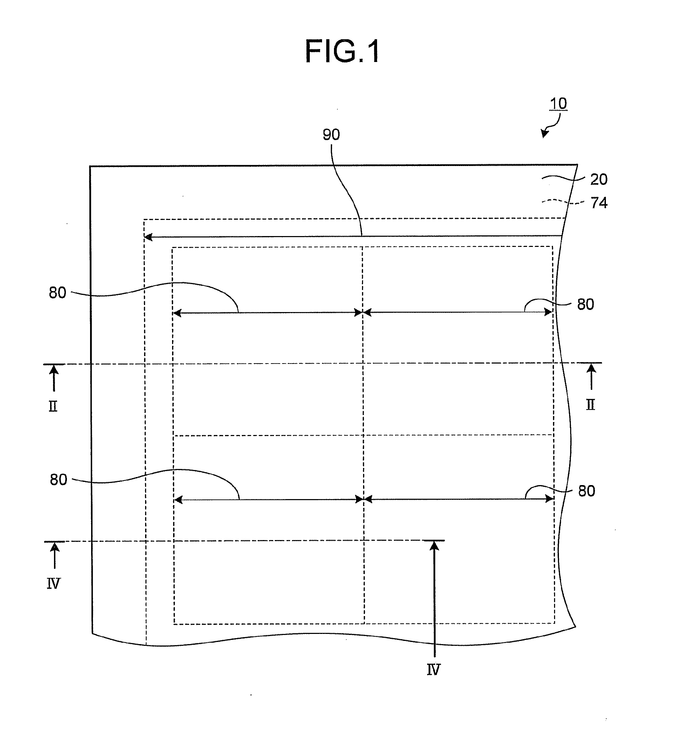

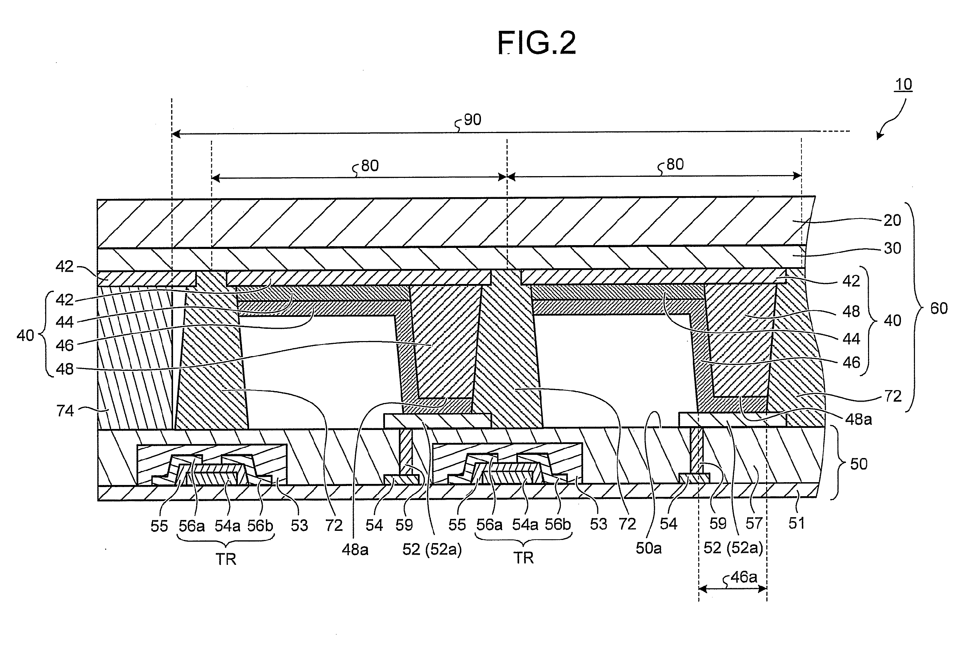

An example of the display panel configuration according to the present invention will now be described with reference to FIGS. 1 and 2.
FIG. 1 is a plan view schematically illustrating the configuration of a display panel. FIG. 1 illustrates a part of a display panel as viewed from above a below-described first substrate side. FIG. 2 is a cross sectional view schematically illustrating the configuration of a display panel as viewed along the cross sectional line II-II in FIG. 1.

As illustrated in Fig. 2, a display panel 10 according to the present invention is formed by laminating a display device substrate 60 and a driving substrate 50 together. A sealing portion 74 is arranged between the display device substrate 60 and the driving substrate 50 at a peripheral portion. The display device substrate 60 and the driving substrate 50 are joined by this sealing portion 74. A gap defined between the display device substrate 60 and the driving substrate 50 is hermetically sealed by the sealing portion 74.

### (Display Device Substrate)

The display device substrate 60 is configured to comprise a first substrate, which is equipped with a color filter on which a plurality of filter elements that selectively output light in a specific wavelength are arranged, and a plurality of organic EL elements provided on the first substrate.
A first substrate 20 has a certain light-transmitting property. In the present specification, "light" means an electromagnetic wave having a wavelength in the range of from about 1 nm to 1 mm. Further, the "light-transmitting property" means that at least a part of the light having a predetermined wavelength incident on a member is output.
It is preferred that the first substrate 20 has a light-transmitting property with respect to visible light. Here, "visible light" means an electromagnetic wave having a wavelength in the range that can be seen by the human eye. Visible light usually means light having a wavelength of about 360 nm to 830 nm. The light transmittance of the first substrate 20 is preferably high, for example, 10% or higher. More preferred is 25% or higher, and even more preferred is 50% or higher.

An insulating substrate that has a light-transmitting property, for example a glass substrate, can be used for the first substrate 20. Further, a quartz substrate, a plastic substrate and the like may also be used for the first substrate 20. The first substrate 20 may be a rigid substrate or a flexible substrate. For example, by using a flexible substrate, a device can be realized whose overall structure is flexible.

As illustrated in FIG. 1, a display region 90 for displaying image information on the display device is set in the first substrate 20. A plurality of element regions 80 individually provided with the plurality of organic EL elements are set in the display region 90. One organic EL element is provided per one element region 80. The plurality of element regions 80 are arranged in a matrix shape in the display region 90.

Of the two main surfaces of the first substrate 20, one of the main surfaces is provided with a color filter 30. The color filter 30 is equipped with a plurality of filter elements that selectively output light at a specific wavelength. The color filter 30 selectively outputs light in specific wavelengths by separating or converting light incident from the light-emitting organic EL elements (the color filter 30 will be described in more detail below).

A plurality of organic EL elements 40 having the same structure as each other are provided on the color filter 30. As described above, the plurality of organic EL elements 40 are provided in the respective element regions 80. Each organic EL element 40 is formed from the same constituent elements, and has the same layered structure.
A lattice-shaped partition wall 72 for dividing each element region 80 is also provided on the color filter 30. The partition wall 72 has an electrical insulating property, so that each element region 80 is electrically insulated. An organic EL element 40 is provided in each element region 80 divided by the partition wall 72.

The partition wall 72 may be formed from a part that exhibits an insulating property. Examples of the material of the partition wall 72 contain inorganic materials such as silicon insulators, such as SOG (spin on glass), a silicon oxide (SiO₂), and a silicon nitride (SiNₓ), aluminum oxides such as alumina (Al₂O₃), hafnium oxides such as hafnia (HfO₂), yttrium oxides such as yttria (Y₂O₃), and lanthanum oxides such as La₂O₃, and organic materials such as photosensitive resins. The partition wall 72 may be formed by photolithography using a photosensitive resin, for example. The partition wall 72 may have a single layer structure, or a multi-layer structure. For example, the partition wall 72 can have a bi-layer structure formed by first forming an inorganic layer by a method such as a vapor deposition method and a sputtering method, and then forming an organic layer on the inorganic layer by photolithography using a photosensitive resin.

The organic EL elements 40 have a first electrode 42, an organic electroluminescent layer (hereinafter, sometimes referred to as "organic EL layer") 42, a second electrode 46, and a contact spacer 48 that corresponds to a protruding portion.
The first electrode 42 is provided on the color filter 30. A plurality of wiring patterns connected to the organic EL elements 40 are further provided on the color filter 30. The first electrode 42 is integrally formed with the plurality of wiring patterns.
The second electrode 46 is arranged facing the first electrode 42. The organic EL layer 44 is sandwiched by the first electrode 42 and the second electrode 46. The organic EL layer 44 is formed from one layer or two or more layers including at least a light-emitting layer (the specific structure of the organic EL elements 40 will be described below).

The contact spacer 48 is formed in a protruding manner in a direction separated away from the first substrate 20 so as to protrude from the color filter 30.
In the present embodiment, the contact spacer 48 is formed on the first electrode 42, and is arranged on the periphery of the element region 80 so as to be in contact with the partition wall 72. The contact spacer 48 is provided to secure an electrical connection with a connection portion formed on the driving substrate 50, which is arranged facing the display device substrate 60. The contact spacer 48 may have a predetermined shape, such as a circular, square or similar column shape, or a circular, square or similar pyramid shape. In the present embodiment, the contact spacer 48 has a square frustum shape (mesa shape) that has a top face 48a. It is preferred to form the contact spacer 48 using parts that have an electrical insulating property, such as a photosensitive resin for example.

The second electrode 46 according to the present embodiment corresponds to a connection electrode on which a connection terminal is formed. The second electrode 46 is stacked on the organic EL layer 44, and is formed extending along the side wall up to the top face of the contact spacer 48. The portion in the second electrode 46 that is formed on the top face 48a of the contact spacer 48 functions as a connection terminal 46a. Thus, it is preferred to provide a protruding connection terminal 46a by forming the connection terminal 46a on the contact spacer 48.

It should be noted that a plurality of not-illustrated spacer members are provided on the color filter 30. These spacer members are provided to maintain a predetermined distance between the display device substrate 60 and the driving substrate 50 across the whole display region 90. The spacer members can be realized by a socalled photo spacer (PS). A photo spacer may be used for the above contact spacer 48. It is preferred to form the contact spacer 48 and the spacer members by the same process using the same material as for a photo spacer.

### (Driving Substrate)

The driving substrate 50 comprises a driving circuit for individually driving and controlling the organic EL elements 40, and a connection portion that establishes electrical connection to this driving circuit. The driving circuit is configured to include wiring, a thin film transistor element, a capacitor element and the like. The driving circuit is formed within the thickness of the driving substrate 50. The driving substrate 50 is realized, for example, by a TFT (thin film transistor) substrate.
The driving substrate 50 has a first main surface 50a and a second main surface 50b. A third electrode 52, which corresponds to a connection portion that establishes electrical connection to the driving circuit, is provided on the first main surface 50a of the driving substrate 50. This third electrode 52 outputs the power for driving the organic EL elements 40.

The driving substrate 50 comprises a substrate body 51. An insulating substrate, for example a glass substrate, may be used for the substrate body 51. Further, a quartz substrate, a plastic substrate and the like may also be used for the substrate body 51. The substrate body 51 may be a rigid substrate or a flexible substrate. For example, by using a flexible substrate, a device can be realized whose overall structure is flexible.

A first wiring layer 54 that comprises a plurality of wires is provided on the substrate body 51. The first wiring layer 54 is integrally formed with a gate electrode 54a of a transistor TR.

A first insulating layer 55 is provided as a gate insulating film on the gate electrode 54a.

A second wiring layer 56 is provided on the first insulating layer 55. The second wiring layer 56 comprises a plurality of wires. A part of the second wiring layer 56 functions as a source electrode 56a or drain electrode 56b of the transistor TR.

A semiconductor layer 53 that functions as a channel layer of the transistor TR is provided between the source electrode 56a and the drain electrode 56b.

A second insulating layer 57 that covers the wiring and the driving circuit including the transistor TR and the like and evens out the driving substrate 50 is further provided on the driving substrate 50. A contact hole that pierces through the first wiring layer 54 from the surface of the second insulating layer 57 is provided in the second insulating layer 57. The contact hole is filled with a conductor to provide a contact 59. The third electrode 52 is formed on the contact 59, so that the first wiring layer 54 and the third electrode 52 are electrically connected via the contact 59. As described below, since the second electrode 46 having the connection terminal 46a and the third electrode 52 are electrically connected, the organic EL elements 40 are electrically connected to the transistor TR via the third electrode 52, the contact 59, the first wiring layer 54, and the second wiring layer 56.

In the present embodiment, the light emitted from the organic EL elements 40 is externally extracted via the display device substrate 60. Therefore, the driving substrate 50 may be a substrate that does not transmit light.
The display panel 10 is formed by laminating the driving substrate 50 and the display device substrate 60 together so that a connection portion 52a of the third electrode 52 comes into contact the connection terminal 46a formed on the contact spacer 48.

In the present embodiment, the protruding connection terminal 46a is provided in the display device substrate 60 to secure an electrical connection between the organic EL elements 40 provided on the display device substrate 60 and the driving circuit of the driving substrate 50. However, as another embodiment, an electrical connection may be secured between the organic EL elements 40 provided on the display device substrate 60 and the driving circuit of the driving substrate 50 by forming a protruding connection portion 52a on the driving substrate 50 side by providing a contact spacer on the driving substrate 50, and providing the connection portion 52a on this contact spacer.

### (Organic EL Element)

The configuration of the organic EL elements 40 will now be described.
Known types of organic EL element include fluorescent emission (singlet transition) and phosphorescent emission (triplet transition) type organic EL elements. Either of these may be used for the organic EL element 40.
Each of organic EL elements 40 provided on the display device substrate 60 is formed from the same constituent elements, and has the same layered structure. The organic EL elements 40 emit light in wavelength ranges that enable a color display by passing the light through the color filter 30. The color filter 30 is preferably a color separation type. In such a case, it is preferred to provide organic EL elements 40 that emit white light in the visible wavelength region on the display device substrate 60.

As described above, the organic EL elements 40 have a first electrode 42 and a second electrode 46. The first electrode 42 is either an anode or a cathode, and the second electrode 46 is the other of the anode or cathode. In the present embodiment, the first electrode 42 corresponds to the anode (hereinafter, the first electrode 42 is sometimes referred to as "anode 42"), and the second electrode 46 corresponds to the cathode (hereinafter, the second electrode 46 is sometimes referred to as "cathode 46"). As described above, the first electrode 42 is provided on the color filter 30.

The first electrode 42 is formed from an electrode that has a light transmitting property, so that the light emitted from the organic EL layer 44 can be externally extracted via the first electrode 42 and the color filter 30. As the first electrode 42, a metal oxide film, a metal thin film and the like may be used. For example, a thin film formed from indium oxide, zinc oxide, tin oxide, indium tin oxide (ITO), indium zinc oxide (IZO), gold, platinum, silver, copper and the like may be used for the first electrode 42. Among these, it is preferred that the first electrode 42 be formed using a thin film of ITO, IZO, and tin oxide.

Next, the light-emitting layer of the organic EL layer 44 will be described. The light-emitting layer can be formed by a vapor deposition method or a coating method, for example. Low molecular materials or macromolecular materials may be used as the material for the light-emitting layer. Especially, macromolecular materials can be preferably used in a coating method, because they easily dissolve in a solvent. Therefore, macromolecular materials that can be applied in a simple coating method is preferred as the light-emitting layer material. In the present specification, the term "macromolecular" refers to a material having a number average molecular weight in terms of polystyrene of 10³ or more, and usually a number average molecular weight in terms of polystyrene of 10⁸ or less.

The light-emitting layer comprised by the organic EL layer 44 is configured to contain an organic substance that emits fluorescent light and/or phosphorescent light, or an organic substance and a dopant. Examples of the light-emitting materials that mainly constitute the light-emitting layer may include the following.

### <Pigment Material>

Examples of a pigment light-emitting material may include a polymer prepared by polymerizing cyclopentamine derivatives, tetraphenyl butadiene derivative compounds, triphenylamine derivatives, oxadiazole derivatives, a pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, quinacridone derivatives, coumarin derivatives, and a pyrazoline dimers.

### <Metal Complex Material>

Examples of a metal complex light-emitting material may include a polymer prepared by polymerizing a metal complex having, for a central metal, Al, Zn, Be and the like, or a rare earth metal such as Tb, Eu, and Dy, and for a ligand, an oxadiazole, a thiadiazole, a phenylpyridine, a phenylbenzimidazole, a quinoline structure and the like.

Further examples of a metal complex light-emitting material may include a polymer prepared by polymerizing a metal complex which emits light from a triplet excited state, such as an indium complex and a platinum complex, an aluminum quinolinol complex, a benzoquinolinol beryllium complex, a benzoxazolyl zinc complex, a benzothiazole zinc complex, an azomethyl zinc complex, a porphyrin zinc complex, and a europium complex.

Examples of a macromolecular light-emitting material may include poly(para-phenylenevinylene) derivatives, polythiophene derivatives, poly-para-phenylene derivatives, polysilane derivatives, polyacetylene derivatives, polyfluorene derivatives, and polyvinylcarbazole derivatives.

### <Dopant Material>

In addition to the above-described light-emitting materials, a dopant material may be further contained in the light-emitting materials constituting the light-emitting layer for the purpose of improving the light-emitting efficiency or changing the light-emitting wavelength. Examples of such a dopant material may include perylene derivatives, coumarin derivatives, rubrene derivatives, quinacridone derivatives, squalium derivatives, porphyrin derivatives, styryl dyes, tetracene derivatives, pyrazolone derivatives, decacyclene, and phenoxazone.

### (Second Electrode)

It is preferred that the material forming the second electrode 46 has a small work function and allows easy electron injection into the light-emitting layer. Further, the material for the second electrode 46 preferably has a high electrical conductivity. As aforesaid, in the present embodiment, since light is extracted from the first electrode 42 side, it is preferred that the second electrode 46 reflect the light emitted from the light-emitting layer to the first electrode 42 side.

Examples of materials which may be used for the second electrode 46 may include metals such as an alkali metal, an alkali earth metal, a transition metal, and Group 13 metals of the periodic table. Specific examples of the material used for the second electrode 46 include metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two kinds or more of these metals, an alloy of one kind or two or more kinds of these metals and one kind or two or more kinds of gold, silver, platinum, copper, manganese, titanium, cobalt, nickel, tungsten, and tin, graphite, and a graphite intercalation compound.

Examples of alloys may include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

### (Functional Layers)

The organic EL layer 44 in the embodiment described with reference to FIGS. 1 and 2 is configured from only a single-layer light-emitting layer. However, as other embodiments, as long as the organic EL layer 44 has at least a light-emitting layer, the organic EL layer 44 provided between the first electrode 42 and the second electrode 46 may also have other predetermined functional layers.

### An example of such functional layers will be described below.

Examples of functional layers that can be provided between the cathode 46 and the light-emitting layer may include an electron injection layer, an electron transport layer, and a hole block layer. When both an electron injection layer and an electron transport layer are provided between the cathode 46 and the light-emitting layer, the layer positioned on the side closer to the cathode 46 is called an electron injection layer, and the layer positioned on the side closer to the light-emitting layer is called an electron transport layer.

Examples of functional layers that can be provided between the anode 42 and the light-emitting layer may include a hole injection layer, a hole transport layer, and an electron block layer. When both a hole injection layer and a hole transport layer are provided between the anode 42 and the light-emitting layer, the layer positioned on the side closer to the anode 42 is called a hole injection layer, and the layer positioned on the side closer to the light-emitting layer is called a hole transport layer.

The electron injection layer and the hole injection layer may be collectively referred to as charge injection layers, and the electron transport layer and the hole transport layer may be collectively referred to as charge transport layers.

Specific examples of the layered structure which the organic EL element 40 may have are illustrated below.
a) Anode / light-emitting layer / cathode
b) Anode / hole injection layer / light-emitting layer /cathode
c) Anode / hole injection layer / light-emitting layer /electron injection layer / cathode
d) Anode / hole injection layer / light-emitting layer /electron transport layer / cathode
e) Anode / hole injection layer / light-emitting layer /electron transport layer / electron injection layer /cathode
f) Anode / hole injection layer / hole transport layer /light-emitting layer / cathode
g) Anode / hole injection layer / hole transport layer /light-emitting layer / electron injection layer / cathode
h) Anode / hole injection layer / hole transport layer /light-emitting layer / electron transport layer / electron injection layer / cathode
i) Anode / light-emitting layer / hole injection layer /cathode
j) Anode / light-emitting layer / electron transport layer / electron injection layer / cathode (here, the symbol "/" represents the fact that respective layers on either side of the "/" are laminated adjacent to each other)

The organic EL element 40 may also have two or more light-emitting layers. Examples of an organic EL element having two light-emitting layers may include the layer structure illustrated in the following k).
k) Anode / charge injection layer / hole transport layer / light-emitting layer / electron transport layer / charge injection layer / charge generation layer / charge injection layer / hole transport layer / light-emitting layer / electron transport layer / charge injection layer /cathode
   Specific examples of an organic EL element having three or more light-emitting layers include, wherein (charge generation layer / charge injection layer / hole transport layer / light-emitting layer / electron transport layer / charge injection layer) is a repeating unit A, the layer structure illustrated in the following l) which includes two or more of repeating unit A.
l) Anode / charge injection layer / hole transport layer / light-emitting layer / electron transport layer / charge injection layer / (repeating unit A) / (repeating unit A) / ... / cathode
In the above-described layer structures k) and l), depending on the design, the layers other than the anode, cathode, and light-emitting layer may optionally be omitted.

Here, the charge generation layer is a layer which generates holes and electrons from the application of an electric field. The charge generation layer is preferably formed from a thin film formed from, for example, vanadium oxide, indium tin oxide, or molybdenum oxide.

To improve adhesion with the electrodes and to improve electron injection from the electrodes, the organic EL elements 40 may be further provided with an insulating layer having a thickness of about 2 nm or less adjacent to the electrodes. Further, to improve adhesion at the interfaces and to prevent mixing, a thin buffer layer may be inserted between layers adjacent to each other.

A specific structure of the respective functional layers will now be described.

### <Hole Injection Layer>

The hole injection layer has a function for improving the hole injection efficiency from the anode. Examples of the hole injection material constituting the hole injection layer may include phenylamines, starburst-type amines, phthalocyanines, oxides such as vanadium oxide, molybdenum oxide, ruthenium oxide, and aluminum oxide, amorphous carbon, polyanilines, and polythiophene derivatives.

The hole injection layer can be formed by, for example, a coating method in which a coating solution containing the above-described hole injection material dissolved in a solvent is coated. An arbitrary preferred solvent may be used, as long as the materials forming the hole injection layer dissolve in such a solvent.

Examples of solvents that can be used may include water, chlorinated solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate.

It is preferred to form the hole injection layer by, for example, a coating method. Examples of coating methods may include a spin coating method, a casting method, a micro gravure coating method, a gravure coating method, a bar coating method, a roll coating method, a wire bar coating method, a dip coating method, a spray coating method, a screen printing method, a flexographic printing method, an offset printing method, an inkjet printing method. The hole injection layer may be formed using one of these coating methods, by a coating method the above-described coating solution on the substrate 100 on which the anode 42 is formed.

The optimum thickness of the hole injection layer depends on the used materials. An arbitrary preferred thickness of the hole injection layer can be selected, as long as pin holes do not form and the driving voltage and light-emitting efficiency are appropriate values. However, if the thickness of the hole injection layer is too thick, the driving voltage of the device increases. Therefore, the hole injection layer has a thickness of, for example, 1 nm to 1 µm, preferably from 2 nm to 500 nm, and more preferably from 5 nm to 200 nm.

### <Hole Transport Layer>

The hole transport layer has a function for improving hole injection from the anode or the hole injection layer, or from a hole transport layer which is closer to the anode. Examples of the hole transport layer material constituting the hole transport layer may include polyvinylcarbazole or derivatives thereof, polysilane or derivatives thereof, polysiloxane derivatives having an aromatic amine in a side chain or in the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylenevinylene) or derivatives thereof.

Among these, as the hole transport material, it is preferred to use a macromolecular hole transport material, such as polyvinylcarbazole or derivatives thereof, polysilane or derivatives thereof, polysiloxane derivatives having an aromatic amine compound group in a side chain or in the main chain, polyaniline or derivatives thereof, polythiophene or derivatives thereof, polyarylamine or derivatives thereof, poly(p-phenylenevinylene) or derivatives thereof, or poly(2,5-thienylenevinylene) or derivatives thereof. Further, more preferably, the hole transport material is a polyvinylcarbazole or derivative thereof, polysilane or derivative thereof, or a polysiloxane derivative having an aromatic amine in a side chain or in the main chain. When using a low molecular weight hole transport material, it is preferred to use such a material by dispersing it in a macromolecular binder.

Examples of the method for forming the hole transport layer include, when using a low molecular weight hole transport material, a film-forming method that uses a mixed solution with a macromolecular binder. Further, when using a macromolecular hole transport material, a film-forming method that uses a solution may be used.

The solvent used in such a film-forming method that uses a solution is not especially limited, as long as the solvent dissolves the hole transport material. Examples of the solvent may include chlorinated solvents such as chloroform, methylene chloride, and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate, and ethyl cellosolve acetate.

Examples of film-forming methods that use a solution may include the same coating methods as those mentioned above as methods for forming the hole injection layer.

As the mixed macromolecular binder, it is preferred to use a binder that does not excessively inhibit charge transportation, and also preferred to use a binder that has a weak absorbance of visible light. Examples of such a macromolecular binder may include polycarbonate, polyacrylate, polymethyl acrylate, polymethyl methacrylate, polystyrene, polyvinyl chloride, and polysiloxane.

The optimum thickness of the hole transport layer depends on the used materials. The thickness is selected so that pin holes do not form and so that the driving voltage and the light-emitting efficiency are appropriate values. If the thickness of the hole transport layer is too thick, the driving voltage of the device may increase. Therefore, the hole transport layer has a thickness of, for example, from 1 nm to 1 µm, preferably from 2 nm to 500 nm, and more preferably from 5 nm to 200 nm.

### <Electron Transport Layer>

The electron transport layer has a function for improving electron injection from the cathode 46 or the electron injection layer, or from an electron transport layer which is closer to the cathode 46. Examples of the electron transport material constituting the electron transport layer may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or derivatives thereof, polyquinoline or derivatives thereof, polyquinoxaline or derivatives thereof, and polyfluorene or derivatives thereof.

Among these, as the electron transport material, preferable are oxadiazole derivatives, benzoquinone or derivatives thereof, anthraquinone or derivatives thereof, metal complexes of 8-hydroxyquinoline or derivatives thereof, polyquinoline or derivatives thereof, polyquinoxaline or derivatives thereof, and polyfluorene or derivatives thereof, and more preferable are 2-(4-biphenylyl)-5-(4-t-butylphenyl)-1,3,4-oxadiazole, benzoquinone, anthraquinone, tris(8-quinolinol)aluminum, and polyquinoline.

Examples of methods for forming the electron transport layer may include, when using a low molecular weight electron transport material, a vacuum vapor deposition method using a powder, and a film-forming method from a solution state or a molten state. When using a macromolecular electron transport material, examples may include a method in which the layer is formed from a solution state or a molten state. When forming the layer from a solution state or a molten state, a macromolecular binder may be additionally used. Examples of film-forming methods for forming the electron transport layer using a solution may include the same methods as described above for forming the hole transport layer using a solution.

The optimum thickness of the electron transport layer depends on the used materials. The electron transport layer needs to be thick enough so that pin holes do not form. The thickness may be selected so that the driving voltage and the light-emitting efficiency are appropriate values. If the thickness of the electron transport layer is too thick, the driving voltage of the device may increase. Therefore, the electron transport layer has a thickness of, for example, from 1 nm to 1 µm, preferably from 2 nm to 500 nm, and more preferably from 5 nm to 200 nm.

### <Electron Injection Layer>

The electron injection layer has a function for improving the electron injection efficiency from the cathode 46. The electron injection material constituting the electron injection layer may be selected based on the type of light-emitting layer. Examples may include an alkali metal, an alkali earth metal, alloys containing one kind or more of such metals, and an oxide, a halide, or a carbonate of such metals, and mixtures thereof.

Examples of the alkali metal or an oxide, a halide, or a carbonate thereof may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, lithium carbonate and the like.

Examples of the alkali earth metal or an oxide, a halide, or a carbonate thereof may include magnesium, calcium, barium, strontium, magnesium oxide, magnesium fluoride, calcium oxide, calcium fluoride, barium oxide, barium fluoride, strontium oxide, strontium fluoride, magnesium carbonate and the like.

The electron injection layer may be formed from a layered body in which two or more layers are stacked. Specific examples of the layered body may include LiF/Ca. The electron injection layer may be formed by a vapor deposition method, a sputtering method, a printing method or the like. It is preferred that the electron injection layer has a thickness of about 1 nm to 1 µm, for example.

The electron block layer has a function for blocking electron transportation. If the hole injection layer and/or hole electron transport layer have a function for blocking electron transportation, these layers may simultaneously serve as the electron block layer. The fact that the electron block layer has a function for blocking electron transportation may be confirmed by, for example, manufacturing a device through which only a hole current flows, and confirming whether there is a blocking effect due to a decrease in the current value.

The hole block layer has a function for blocking hole transportation. If the electron injection layer and/or electron transport layer have a function for blocking hole transportation, these layers can simultaneously serve as a hole block layer. The fact that the hole block layer has a function for blocking hole transportation may be confirmed by, for example, manufacturing a device through which only a hole current flows, and confirming whether there is a blocking effect due to a decrease in the current value.

### (Color Filter)

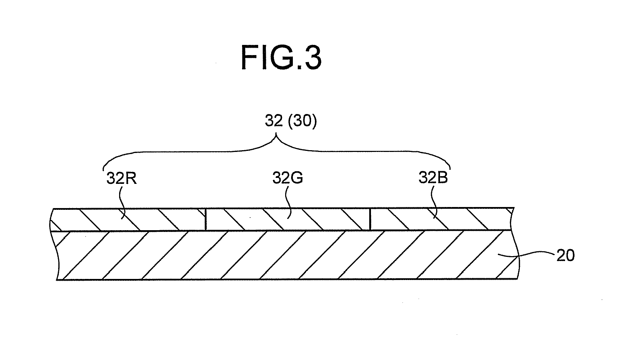

A configuration example of the color filter 30 will now be described with reference to FIG. 3. FIG. 3 is a schematic cross sectional view for illustrating the configuration of the color filter.
The color filter 30 is provided on the main surface of the first substrate 20. The color filter 30 according to the present embodiment is configured from only a filter layer (colored layer) 32. In other words, the color filter 30 does not have a black matrix (BM) or a base coat (protective layer) as constituent elements.

The filter layer 32 has a red filter element 32R, a green filter element 32G, and a blue filter element 32B. The red filter element 32R, green filter element 32G, and blue filter element 32B are arranged corresponding to predetermined pixels, respectively. The filter elements 32R, 32G, and 32B are arranged so that any one of them corresponds to a single element region 80. A plurality of organic EL elements are provided so as to lie over the filter elements 32R, 32G, and 32B when viewing in the thickness direction of the first substrate 20, respectively.

### Examples of the material for the filter layer 32 may include two types, (i) dye (organic) materials and (ii) pigment (inorganic) materials.

Examples of (i) dye materials may include acid dyes, oil-soluble dyes, disperse dyes, reactive dyes, and direct dyes. Specific examples of dye materials may include azo dyes, benzoquinone dyes, naphthoquinone dyes, anthraquinone dyes, cyanine dyes, squarilium dyes, croconium dyes, melocyanine dyes, stilbene dyes, diphenylmethane dyes, triphenylmethane dyes, fluoran dyes, spiropyran dyes, phthalocyanine dyes, indigo dyes, flugide dyes, nickel complex dyes, and azulene dyes.

Examples of the (ii) pigment dyes may include: a perylene compound pigment such as C.I. Pigment Red 190 (C.I. No. 71140), C.I. Pigment Red 224 (C.I. No. 71127), and C.I. Pigment Violet 29 (C.I. No. 71129); a perynone compound pigment such as C.I. Pigment Orange 43 (C.I. No. 71105) and C.I. Pigment Red 194 (C.I. No. 71100); a quinacridone compound pigment such as C.I. Pigment Violet 19 (C.I. No. 73900), C.I. Pigment Violet 42, C.I. Pigment Red 122 (C.I. No. 73915), C.I. Pigment Red 192, C.I. Pigment Red 202 (C.I. No. 73907), C.I. Pigment Red 207 (C.I. Nos. 73900 and 73906), and C.I. Pigment Red 209 (C.I. No. 73905); a quinacridonequinone compound pigment such as C.I. Pigment Red 206 (C.I. No. 73900/73920), C.I. Pigment Orange 48 (C.I. No. 73900/73920), and C.I. Pigment Orange 49 (C.I. No. 73900/73920); an anthraquinone compound pigment such as C.I. Pigment Yellow 147 (C.I. No. 60645); an anthanthrone compound pigment such as C.I. Pigment Red 168 (C.I. No. 59300); a benzimidazolone compound pigment such as C.I. Pigment Brown 25 (C.I. No. 12510), C.I. Pigment Violet 32 (C.I. No. 12517), C.I. Pigment Yellow 180 (C.I. No. 21290), C.I. Pigment Yellow 181 (C.I. No. 11777), C.I. Pigment Orange 62 (C.I. No. 11775), and C.I. Pigment Red 185 (C.I. No. 12516); a condensed disazo compound pigment such as C.I. Pigment Yellow 93 (C.I. No. 20710), C.I. Pigment Yellow 94 (C.I. No. 20038), C.I. Pigment Yellow 95 (C.I. No. 20034), C.I. Pigment Yellow 128 (C.I. No. 20037), C.I. Pigment Yellow 166 (C.I. No. 20035), C.I. Pigment Orange 34 (C.I. No. 21115), C.I. Pigment Orange 13 (C.I. No. 21110), C.I. Pigment Orange 31 (C.I. No. 20050), C.I. Pigment Red 144 (C.I. No. 20735), C.I. Pigment Red 166 (C.I. No. 20730), C.I. Pigment Red 220 (C.I. No. 20055), C.I. Pigment Red 221 (C.I. No. 20065), C.I. Pigment Red 242 (C.I. No. 20067), C.I. Pigment Red 248, C.I. Pigment Red 262, and C.I. Pigment Brown 23 (C.I. No. 20060); a disazo compound pigment such as C.I. Pigment Yellow 13 (C.I. No. 21100), C.I. Pigment Yellow 83 (C.I. No. 21108), and C.I. Pigment Yellow 188 (C.I. No. 21094); an azo compound pigment such as C.I. Pigment Red 187 (C.I. No. 12486), C.I. Pigment Red 170 (C.I. No. 12475), C.I. Pigment Yellow 74 (C.I. No. 11714), C.I. Pigment Yellow 150 (C.I. No. 48545), C.I. Pigment Red 48 (C.I. No. 15865), C.I. Pigment Red 53 (C.I. No. 15585), C.I. Pigment Orange 64 (C.I. No. 12760), and C.I. Pigment Red 247 (C.I. No. 15915); an indanthrone compound pigment such as C.I. Pigment Blue 60 (C.I. No. 69800); a phthalocyanine compound pigment such as C.I. Pigment Green 7 (C.I. No. 74260), C.I. Pigment Green 36 (C.I. No. 74265), Pigment Green 37 (C.I. No. 74255), Pigment Blue 16 (C.I. No. 74100), C.I. Pigment Blue 75 (C.I. No. 74160:2), and 15 (C.I. No. 74160); a triaryl carbonium compound pigment such as C.I. Pigment Blue 56 (C.I. No. 42800) and C.I. Pigment Blue 61 (C.I. No. 42765:1); a dioxazine compound pigment such as C.I. Pigment Violet 23 (C.I. No. 51319) and C.I. Pigment Violet 37 (C.I. No. 51345); an aminoanthraquinone compound pigment such as C.I. Pigment Red 177 (C.I. No 65300); a diketopyrrolopyrrole compound pigment such as C.I. Pigment Red 254 (C.I. No. 56110), C.I. Pigment Red 255 (C.I. No. 561050), C.I. Pigment Red 264, C.I. Pigment Red 272 (C.I. No. 561150), C.I. Pigment Orange 71, and C.I. Pigment Orange 73; a thioindigo compound pigment such as C.I. Pigment Red 88 (C.I. No. 73312); an isoindoline compound pigment such as C.I. Pigment Yellow 139 (C.I. No. 56298) and C.I. Pigment Orange 66 (C.I. No. 48210); an isoindolinone compound pigment such as C.I. Pigment Yellow 109 (C.I. No, 56284) and C.I. Pigment Orange 61 (C.I. No. 11295); a pyranthrone compound pigment such as C.I. Pigment Orange 40 (C.I. No. 59700) and C.I. Pigment Red 216 (C.I. No. 59710); and an isoviolanthrone compound pigment such as C.I. Pigment Violet 31 (60010). Among these, a quinacridone compound pigment, a diketopyrrolopyrrole compound pigment, a dioxazine compound pigment, a phthalocyanine compound pigment, and an azo compound pigment are preferred as the pigment material, and a diketopyrrolopyrrole compound pigment and a dioxazine compound pigment are more preferred.

When forming the organic EL elements 40 on this color filter 30, to adjust the film-forming properties of the formed layer, it is preferred to perform a surface treatment to make the exposed surfaces hydrophobic or hydrophilic. For example, hydrophilicity may be imparted by performing a coating treatment that uses HMDS (hexamethyldisilazane) or a plasma treatment that using CF₄ gas. Further, hydrophobicity may be imparted by performing a plasma treatment that uses O₂ gas.
Depending on the type of dye or pigment material, the solvent used in the dye or pigment material may remain in the filter layer, and the resultant residue may gradually evaporate causing the organic EL elements to degrade. Accordingly, depending on the type of dye or pigment material, it may be preferred to provide a base coat, which protects the organic EL elements from the gases produced by the filter layer. If a base coat cannot be provided, it is preferred to form the filter layer 32 using a dye material.

### <Manufacturing Method for Display Device Substrate>

First, the first substrate 20 predetermined the display region 90 is prepared, and then the color filter 30 is formed. A substrate on which the color filter 30 has been pre-formed may be commercially obtained. Next, the first electrode 42 formed from an ITO thin film, for example, is formed on the filter layer 32.

Next, the above-described partition wall 72, contact spacer 48, and photo spacers are formed. These parts may be individually formed, or the partition wall 72, contact spacer 48, and photo spacers may be formed in the same step using the same material. The partition wall 72, contact spacer 48, and photo spacers may be formed by a photolithography process using a photosensitive resin as a material. Forming the partition wall 72, contact spacer 48, and photo spacers in the same step in this manner allows the manufacturing steps to be simplified. As a result, a rise in the failure rate due to an increase in the number of steps can be suppressed, productivity can be improved, and even the production costs can be reduced.
In addition, it is preferred to form the plurality of organic EL elements 40 on the color filter 30 by forming the organic EL layer 44 and the second electrode 46 by the above-described method.

### <Manufacturing Method for Display Panel>

An embodiment of the method for manufacturing the display panel according to the present invention will now be described in detail with reference to the drawings.

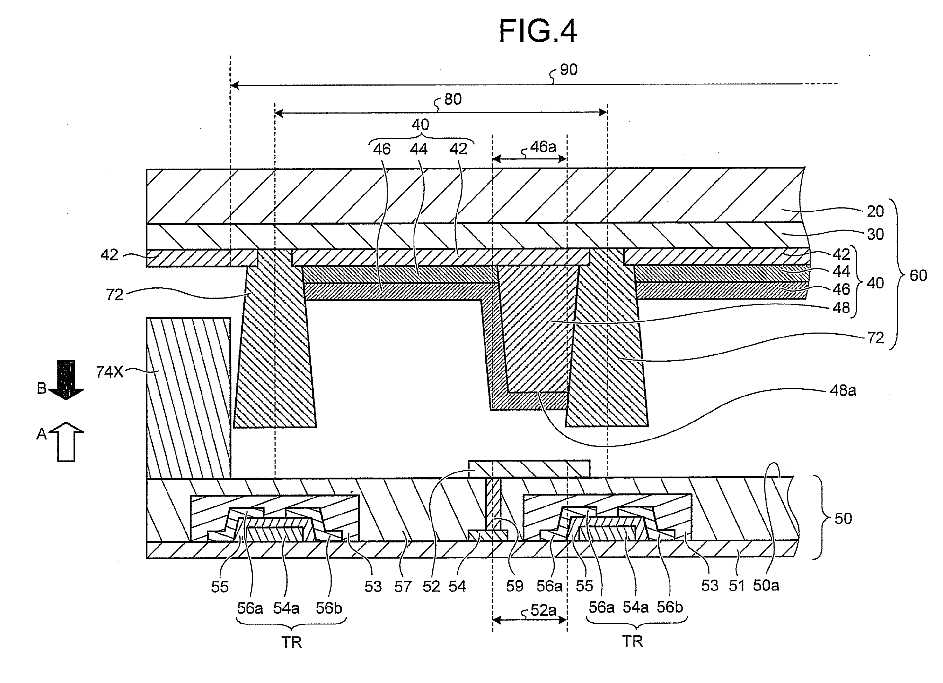

FIG. 4 is a diagram schematically illustrating a cross section when a display panel is laminated as viewed along the cross sectional line IV-IV in FIG. 1.
In the method for manufacturing the display panel according to the present embodiment, the display device substrate 60, on which the color filter 30 and organic EL elements 40 are formed, and the driving substrate 50 are prepared, and then these layers are laminated facing each other. The driving substrate 50 can be prepared by obtaining a commercially-available TFT substrate.
In the method for manufacturing the display panel according to the present embodiment, the color filter 30 and the organic EL elements 40 might be degraded by heating. Consequently, in steps that require a heat treatment, it is preferred to perform the heat treatment at 200°C or less.

The display device substrate 60 and the driving substrate 50 are arranged facing each other (refer to FIG. 4). Although in FIG. 4 the display device substrate 60 is arranged above the driving substrate 50, as another embodiment, the laminating step may be carried out by arranging the driving substrate 50 above the display device substrate 60. In this step, for example, it is preferred to use a platen capable of detachably holding various types of substrate.

Next, with the display device substrate and the driving substrate laminated, a laminating material is arranged on the surface of the display device substrate or driving substrate so as to enclose the plurality of organic EL elements. In the present embodiment, a linear laminating material 74X is provided on the driving substrate 50 so as to enclose the predetermined display region 90 (refer to FIG. 4). Although in FIG. 4 the laminating material 74X is provided on the driving substrate 50, as another embodiment, the laminating material 74X may be provided on the display device substrate 60.

Next, the display device substrate 60 and the driving substrate 50 are positioned so that the connection terminal 46a and the connection portion 52a are overlapped when viewing in a substrate thickness direction.

Next, the display device substrate 60 and the driving substrate 50 are laminated. This laminating step may be performed by fixing the driving substrate 50, and then moving the display device substrate 60 in the direction of the black arrow B (refer to FIG. 4). Alternatively, the display device substrate 60 may be fixed, and the driving substrate 50 moved in the direction of the white arrow A.

Thus, by laminating the display device substrate 60 and the driving substrate 50 together, the connection terminal 46a and the connection portion 52a abut each other, and the display region 90 is hermetically sealed by the driving substrate 50, the display device substrate 60, the partition wall 72, and the laminating material 74X. Since the connection terminal 46a and the connection portion 52a come into contact each other, the driving circuit and the organic EL elements are electrically connected.

It is preferred to perform this sealing step by (i) a laminating step in a vacuum or (ii) a laminating step in a nitrogen atmosphere. These steps will now be described below.

### (i) Laminating Step in a Vacuum

Lamination is carried out by turning a gap defined between the driving substrate 50 and the display device substrate 60 into a vacuum. For example, it is preferred to carry out the laminating step under a condition in which the gap defined between the driving substrate 50 and the display device substrate 60 is vacuumized, by laminating the driving substrate 50 and the display device substrate 60 in a reduced-pressure vacuum chamber. In the present specification, the term "vacuum" refers to a state in which the pressure is below atmospheric pressure. The degree of vacuum under which the laminating step is carried out can be appropriately set in a range that does not harm the purpose of the present invention. Preferably, the degree of vacuum is 1×10⁻³ Pa or less.

If the laminating step is thus performed in a vacuum, the duration that the organic EL elements formed on the display device substrate 60 are in contact with moisture and oxygen in the air during the manufacturing steps can be shortened. Further, since the driving substrate 50 and the display device substrate 60 are hermetically sealed, the gap defined between the driving substrate 50 and the display device substrate 60 can be maintained in a vacuum state even after the laminating step. Consequently, gases that cause the organic EL elements to degrade can be prevented from contacting the organic EL elements, so that degradation of the organic EL elements can be effectively prevented.

The laminating step does not have to be carried out in a vacuum chamber. The laminating step may be carried out by holding the driving substrate 50 and the display device substrate 60 with a member that encloses the periphery of these substrates, and laminating them while reducing the pressure of only the gap defined between the driving substrate 50 and the display device substrate 60. When thus turning only the gap defined between the driving substrate 50 and the display device substrate 60 into a vacuum, the volume of the gap that needs to be turned into a vacuum can be minimized. As a result, the time required to achieve the predetermined degree of vacuum can be shortened. Consequently, the time required for the laminating step can be shortened, and productivity can thus be improved.

Thus, if the laminating step is carried out under a condition in which the gap defined between the driving substrate 50 and the display device substrate 60 is vacuumized, since the gap defined between the driving substrate 50 and the display device substrate 60 can be maintained in a vacuum state even after the laminating step, the atmospheric pressure is applied on the whole display panel. Due to this applied pressure, an electrical connection can be secured between the connection terminal 46a and the connection portion 52a, and connection resistance can be decreased. Therefore, for example, a pressure welding step can be omitted.

### (ii) Laminating Step in a Nitrogen Atmosphere

Lamination is carried out under a condition in which a gap defined between the driving substrate 50 and the display device substrate 60 is under nitrogen atmosphere. For example, it is preferred to carry out the laminating step under a condition in which the gap defined between the driving substrate 50 and the display device substrate 60 is under nitrogen atmosphere, by laminating the driving substrate 50 and the display device substrate 60 together in a chamber under nitrogen atmosphere.

Even if the laminating step is thus performed under nitrogen atmosphere, the duration that the organic EL elements formed on the display device substrate 60 are exposed to moisture and oxygen in the air during the manufacturing steps can be shortened. Further, since the driving substrate 50 and the display device substrate 60 are hermetically sealed, the gap defined between the driving substrate 50 and the display device substrate 60 continues to have nitrogen atmosphere even after the laminating step. Consequently, gases that causes the organic EL elements to degrade can be prevented from contacting the organic EL elements, so that degradation of the organic EL elements can be effectively prevented.

The laminating step does not have to be carried out in a chamber. The laminating step may be carried out by holding the driving substrate 50 and the display device substrate 60 with a member that encloses the periphery of these substrates, and laminating them while making only the gap defined between the driving substrate 50 and the display device substrate 60 have nitrogen atmosphere. When thus making only the gap defined between the driving substrate 50 and the display device substrate 60 have nitrogen atmosphere, the volume of the gap that needs to be turned into nitrogen atmosphere can be minimized. As a result, the time required to achieve nitrogen atmosphere can be shortened. Consequently, the time required for the laminating step can be shortened, and productivity can thus be improved.

When the laminating step is carried out under a condition in which the gap defined between the driving substrate 50 and the display device substrate 60 is under nitrogen atmosphere, after the laminating step, it is preferred to pressure-weld the connection terminal 46a and the connection portion 52a by applying an arbitrary preferred pressure on the display panel in the direction of the white arrow A and/or black arrow B that are illustrated in FIG. 4.

After the above-described laminating step is finished, the laminating material 74X is cured. This curing treatment can be carried out by a predetermined method based on the type of the laminating material 74X.
As the laminating material 74X, it is preferred to use a frit sealing material which contains a low melting point glass powder. The glass transition temperature of the "low temperature glass" included in this frit sealing material is about 800°C.

The curing treatment of the laminating material 74X is carried out by irradiating laser light having a predetermined wavelength, such as infrared light, on the frit sealing material to heat and fuse the low temperature glass powder. When the fused glass powder is cooled, the glass powder has become a monolithic mass that functions as a sealing portion 74 that exhibits a glass barrier property. The sealing portion 74 formed from a glass material has a high gas barrier against gases, moisture and the like. Consequently, the organic EL elements 40 can be effectively protected from moisture and oxygen in the atmosphere.

Further examples that can be used as the laminating material 74X include UV-curable resins and thermosetting resins. In such a case, the cured product of the laminating material 74X can be made to function as the sealing portion 74 by curing the laminating material 74X with a UV-ray irradiation treatment, a heat treatment and the like.

The thus-manufactured display panel can be assembled with a housing, a power supply device, a driver chip and the like, to manufacture a display device.

### EXPLANATIONS OF LETTERS OR NUMERALS

- 10: display panel

- 20: first substrate
- 30: color filter
- 32: filter layer
- 32R: red filter element
- 32G: green filter element
- 32B: blue filter element
- 40: organic EL element
- 42: first electrode
- 44: organic EL layer
- 46: second electrode
- 46a: connection terminal
- 48: contact spacer
- 50: driving substrate
- 50a: first main surface
- 50b: second main surface
- 51: substrate body
- 52: third electrode
- 52a: connection portion
- 53: semiconductor layer
- 54: first wiring layer
- 54a: gate electrode
- 55: first insulating layer
- 56: second wiring layer
- 56a: source electrode
- 56b: drain electrode
- 57: second insulating layer
- 59: contact
- 60: display device substrate
- 72: partition wall
- 74X: laminating material
- 74: sealing portion
- 80: element region
- 90: display region

## Claims

1. A method for manufacturing a display panel, comprising the steps of:
forming a display device substrate by providing on a first substrate which is equipped with a color filter on which a plurality of filter elements that selectively emit light in a specific wavelength are arranged, a plurality of organic electroluminescent elements which have the same structure as each other and which is individually equipped with a connection electrode formed with a connection terminal, so that each of organic electroluminescent elements is overlapped with each of the filter elements when viewing in a thickness direction of the first substrate;
preparing a driving substrate which comprises a driving circuit for individually driving the plurality of organic electroluminescent elements and a connection portion that establishes electrical connection to the driving circuit;
arranging a laminating material on a surface of the display device substrate or the driving substrate so as to enclose the plurality of organic electroluminescent elements when the display device substrate and the driving substrate are laminated so that the connection terminal and the connection portion come into contact each other; and
a laminating step of laminating the display device substrate and the driving substrate so that the connection terminal and the connection portion come into contact each other.

2. The method for manufacturing a display panel according to claim 1, wherein the step of forming a display device substrate comprises forming the connection terminal in a protruding manner by forming a protruding portion that protrudes from the color filter and providing the connection terminal on the protruding portion.

3. The method for manufacturing a display panel according to claim 1, wherein the laminating step is carried out under a condition in which a gap defined between the display device substrate and the driving substrate is vacuumized.

4. The method for manufacturing a display panel according to claim 1, wherein the laminating step is carried out under a condition in which a gap defined between the display device substrate and the driving substrate is under nitrogen atmosphere, and
the method further comprises, after the laminating step, pressure-welding the connection terminal and the connection portion; and curing the laminating material.

5. The method for manufacturing a display panel according to claim 1, wherein in the step of arranging a laminating material, a frit sealing material that contains a low melting point glass powder is used as the laminating material, and
the method further comprises, after the laminating step, curing the laminating material by irradiating laser light on the frit sealing material.

6. The method for manufacturing a display panel according to claim 1, wherein in the step of forming a display device substrate, the plurality of organic electroluminescent elements are formed by forming a light-emitting layer using a coating method.

7. The method for manufacturing a display panel according to claim 1, wherein in the step of forming a display device substrate, the first substrate which is equipped with the color filter consisting of a colored layer is prepared, and the plurality of organic electroluminescent elements are formed in contact with the colored layer.

8. A display device substrate to be laminated facing a driving substrate that comprises a driving circuit for individually driving a plurality of organic electroluminescent elements and a connection portion which is provided corresponding to each organic electroluminescent element and establishes electrical connection to the driving circuit, the display device substrate comprising:
a first substrate equipped with a color filter on which a plurality of filter elements that selectively emit light in a specific wavelength are arranged; and
the plurality of organic electroluminescent elements having the same structure as each other, each arranged on the first substrate so as to overlap each of filter elements when viewing in a thickness direction of the first substrate, wherein
each of the plurality of organic electroluminescent elements is equipped with a connection electrode on which a connection terminal for connecting to the connection portion is formed.

9. The display device substrate according to claim 8, wherein the plurality of organic electroluminescent elements comprises a light-emitting layer that emits white light.

10. A display panel comprising:
a driving substrate comprising a driving circuit for individually driving a plurality of organic electroluminescent elements, and a connection portion which is provided corresponding to each organic electroluminescent element and establishes electrical connection to the driving circuit; and
the display device substrate according to claim 8, wherein
the display panel is formed by laminating the driving substrate and the display device substrate so that the connection terminal and the connection portion are in a contacting state.

11. A display device comprising the display panel according to claim 10.
